# EUROPÄISCHE PATENTSCHRIFT

(11) **EP 0 852 062 B1**
(45) Veröffentlichungstag und Bekanntmachung des Hinweises auf die Patenterteilung: **06.02.2002**
(21) Anmeldenummer: 96943845.6
(22) Anmeldetag: 28.08.1996
(51) Int. Cl.: H01L 21/225, H01L 21/033, H01L 31/18

(54) **DOTIERVERFAHREN ZUR HERSTELLUNG VON HOMOÜBERGÄNGEN IN HALBLEITERSUBSTRATEN**
DOPING PROCESS FOR PRODUCING HOMOJUNCTIONS IN SEMICONDUCTOR SUBSTRATES
PROCEDE DE DOPAGE POUR LA PRODUCTION D'HOMOJONCTIONS DANS DES SUBSTRATS SEMI-CONDUCTEURS

(30) Priorität: 18.09.1995 DE 19534574
(43) Veröffentlichungstag der Anmeldung: 08.07.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHINDLER, Roland, D-79102 Freiburg (DE)
(74) Vertreter: Münich, Wilhelm, Dr.
(86) Internationale Anmeldenummer: DE9601598
(87) Internationale Veröffentlichungsnummer: WO9711481

(56) Entgegenhaltungen:
- DE-A- 3 402 653
- DE-C- 4 223 403
- GB-A- 2 131 608
- US-A- 4 273 950
- IEEE TRANSACTIONS ON ELECTRON DEVICES, Bd. 39, Nr. 1, 1.Januar 1992, Seiten 105-110, XP000244155 AKIRA USAMI: "SHALLOW-JUNCTION FORMATION ON SILICON BY RAPID THERMAL DIFFUSION OF IMPURITIES FROM A SPIN-ON SOURCE" in der Anmeldung erwähnt

## Beschreibung

### Technisches Gebiet

Die Erfindung bezieht sich auf ein Dotierverfahren zur Herstellung von Homoübergängen in Halbleitersubstraten, in die im Wege eines Diffusionsschrittes Dotierstoffe eindringen. Ferner ist eine Lichtquelle vorgesehen, deren Emissionsspektrum UV-Anteile enthält und die auf die Halbleitersubstratoberfläche gerichtet ist. Ein derartiges Verfahren ist beispielsweise aus IEEE Trans. Electron Devices, Vol. ED 39, 1992, S. 105 bis 110, bekannt.

### Stand der Technik

Zur Herstellung gegeneinander scharf angrenzender Dotierbereiche in Halbleitersubstraten mit jeweils unterschiedlichen Dotierstoffkonzentrationen gleicher Dotierstoffart, d.h. p- oder n-Dotierstoffatome, werden Diffusions- und/oder Implantationstechniken angewendet. Um ausschließlich gezielte Bereiche in Halbleitergrundsubstraten dotieren zu können, werden auf die zu dotierenden Substratoberfläche Masken aufgebracht, die unter den gewählten Diffusions- bzw. Implantationsbedingungen für die Dotierstoffatome undurchlässig sind.

Im Falle von Silizium-Halbleitergrundsubstraten werden auf die Siliziumoberfläche Siliziumoxid-Masken aufgebracht, die entweder thermisch aufgewachsen oder als Schichten abgeschieden werden. Zur Herstellung derartiger Masken ist auf einer homogenen abgeschiedenen Siliziumoxidschicht Photolack aufzubringen, der an geeigneten Stellen mit Hilfe geeigneter Schattenmasken belichtet wird. An den belichteten Stellen erfolgt durch einen nachfolgenden Ätzschritt der lokale Abtrag der Oxidschicht bis hinab zum Grundsubstrat, das nachfolgend lokal mit einer gewünschten Konzentration von Dotierstoffatomen im Wege der Diffusion und/oder Implantation angereichert werden kann. Somit bedarf die gezielte Dotierung von Halbleitergrundsubstraten mit den an sich bekannten Dotiertechniken vorbereitende Strukturierungsmaßnahmen, bei denen die für den Diffusionsvorgang aktive Maskenschicht örtlich vor der Diffusion abgelöst werden muß. Für diesen Schritt ist jedoch wiederum ein Maskenschritt notwendig, durch den die Diffusionssperre lokal entfernt wird.

Insbesondere bei der Herstellung von Solarzellen, die eine Zwei-Stufen-Emitter-Struktur aufweisen sind zwei verfahrenstechnisch aufwendige Diffusionsschritte erforderlich, die mit Mitteln konventioneller Diffusionstechniken bislang durchgeführt werden.

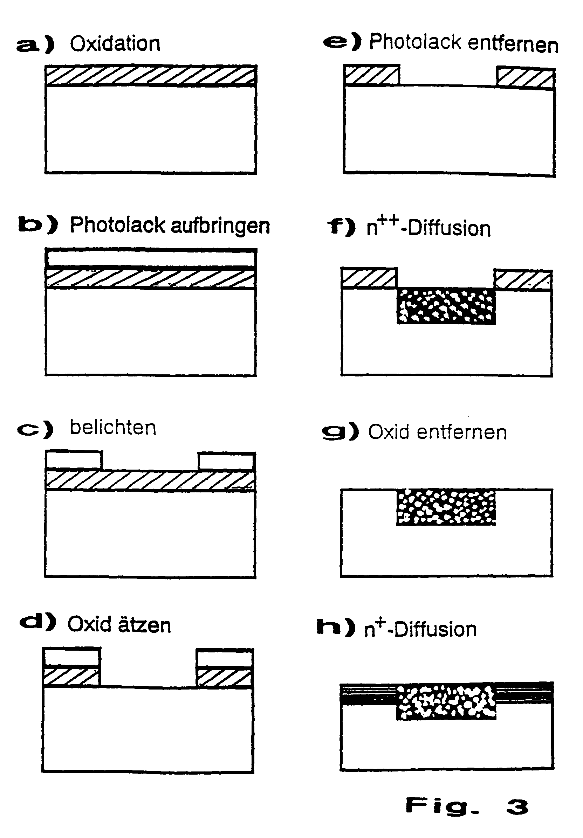

Zur Erläuterung der für die Herstellung einer Zwei-Stufen-Emitter-Solarzelle mit den bekannten Ätz-Diffusionstechniken wird auf die Figur 3 verwiesen, die die Einzelschrittfolgen a bis h zeigt. Im Rahmen eines ersten Hochtemperaturschrittes wird in Figur 3a auf das Grundsubstrat 1 eine Oxidschicht 2 aufgebracht, die in konventionellen prozeßgesteuerten Heizöfen erzeugt werden können. Unter Verwendung üblicher Spin-on-Techniken werden gleichmäßig auf der Oxidschicht ein Photolack aufgebracht, der in einem nachfolgenden Photolithographieschritt unter Verwendung geeigneter Masken belichtet wird (siehe hierzu Figur 3c). Die lichtempfindliche Photoschicht wird an den belichteten Stellen abgetragen, an denen die Oxidschicht freigelegt wird. In einem nachfolgenden Ätzvorgang gemäß Figur 3d erfolgt ein gezielter Abtrag der Oxidschicht an den freigelegten Stellen, so daß ein lokaler Abtrag der Oxidschicht bis zur Grundsubstratoberfläche möglich ist. Nachfolgend gemäß Verfahrensschritt Figur 3e wird der Photolack entfernt. Anschließend erfolgt der erste Diffusionsschritt mit n++-Dotierstoffatomen, die nur über die freie Grundsubstratoberfläche in das Material eindringen können (siehe hierzu den weiß-punktiert dargestellten n++-Dotierstoffbereich). In einem weiteren Verfahrensschritt, der wiederum einem Ätzvorgang entspricht, werden die verbleibenden Oxidbereiche aus der Oberfläche des Grundsubstrates entfernt, so daß in einem nachfolgenden zweiten Diffusionsschritt, der in diesem Falle gemäß Darstellung Figur 3h einer ganzflächigen n+-Diffusion entspricht, ein homogene n+-Dotierung erfolgen kann.

Mit der vorbeschriebenen Verfahrensweise können sogenannte Zwei-Stufen-Emitter-Solarzellen, die aus jeweils zwei angrenzenden n+/n++-Übergängen bestehen, hergestellt werden.

Das für einen Zwei-Stufen-Emitter beschriebene Herstellungsverfahren enthält zwei Diffusionsschritte, wovon der erste Diffusionsschritt eine lokale und tiefere Diffusion und der zweite Diffusionsschritt eine ganzflächige homogene Diffusion vorsieht. Sowohl die Diffusion als auch die Oxidation werden in klassischen Diffusions- bzw. Oxidationsöfen bei sehr hohen Prozeßtemperaturen von > 1000°C durchgeführt.

Im Wege der Bauelementeentwicklung und dem Einsatz neuartiger Materialien und nicht zuletzt um die Leistungsfähigkeit und Zuverlässigkeit von Halbleiterbauelementen zu verbessern, die bedingt durch die bisherigen Rahmenbedingungen der Herstellung wärmeausgesetzter Dotierungsprozessen unterliegen, ist es erforderlich, den Wärmeeintrag während der Herstellungsprozedur zu senken. Unter Wärmeeintrag ist grundsätzlich die Zeitdauer der wärmebeaufschlagten Diffusions- bzw. Oxidationsschritten sowie das absolute Temperaturniveau, das während des Diffusions- bzw. Oxidationsvorganges herrscht, zu verstehen. Um diesem Erfordernis nachzukommen, bedient man sich neuerdings dem sogenannten "Rapid Thermal Processing" (RTP), bei dem die zu bearbeitenden Halbleitersubstrate einzeln optisch beheizt werden.

Im Unterschied zu konventionellen Heizmethoden, die im wesentlichen auf der Einwirkung von Infrarotstrahlung auf das zu beheizende Substrat basiert, verwendet die RTP-Technik strahlungsintensive Beleuchtungseinheiten, die im wesentlichen im ultravioletten Spektralbereich emittieren. Nähere Ausführungen hierzu sind in dem Beitrag von R. Singh "Development Trends in Rapid Isothermal Processing (RIP) dominated Semiconductor Manufacturing" in "1st Int. Rapid Thermal Processing Conf. RTP 93" Scottsdale, Arizona, Eds. Richard Fair und Bohumil Lojek Sept. 1993, Seite 31 bis 42 beschrieben.

Insbesondere hat sich in der Anwendung RTP-Techniken beim Dotieren von Halbleitermaterialien herausgestellt, daß die Diffusionseigenschaften der Dotierstoffatome, die während des Diffusionsprozesses in das zu dotierende Halbleitermaterial eindringen, durch die charakteristischen Heizraten, die durch die neuen Techniken des "Rapid Thermal Processing" erreichbar sind, entscheidend beeinflußt werden können. So geht beispielsweise aus dem Beitrag A. Usami, "Shallow-Junction Formation on Silicon by Rapid Thermal Diffusion of Impurities from a Spin-on Source", IEEE Transactions on Electron Devices, Vol. ED 39, 1992, Seite 105 ff., hervor, daß die Diffusionskoeffizienten durch die Anwendung der neuen, optischen Heizmethoden in einem gewissen Bereich gezielt einstellbar sind.

### Darstellung der Erfindung

Der Erfindung liegt die Aufgabe zugrunde, ein Dotierverfahren zur Herstellung von Homoübergängen in Halbleitersubstraten, in die im Wege der Diffusion Dotierstoffe eindringen, mit einer Lichtquelle, deren Emissionsspektrum UV-Anteile enthält und die auf die Halbleitersubstratoberfläche gerichtet ist, derart weiter zu entwickeln, daß es mit Hilfe der eingangs geschilderten neuen RTP-Techniken möglich sein soll, die Herstellung von Homoübergängen aufweisende Halbleiterbauelementen und insbesondere Zwei-Stufen-Emitter-Solarzellen derart zu vereinfachen, so daß nur ein einziger, wärmebeaufschlagter Bearbeitungsschritt notwendig ist. Die Herstellung derartiger Bauelemente soll verkürzt und im wesentlichen mit erheblich geringeren Kosten verbunden sein. Ferner soll der Wärmeeintrag auf die Halbleiterbauelemente während ihrer Herstellung reduziert werden.

Die Lösung der der Erfindung zugrunde liegende Aufgabe ist im Anspruch 1 angegeben. Vorteilhafte Ausführungsformen sind den Ansprüchen 2ff. zu entnehmen.

Erfindungsgemäß ist ein Dotierverfahren zur Herstellung von Homoübergängen in Halbleitersubstraten, in die im Wege der Diffusion Dotierstoffe eindringen, mit einer Lichtquelle, deren Emissionsspektrum UV-Anteile enthält, und die auf die Halbleitersubstratoberfläche gerichtet ist, derart weitergebildet, daß zwischen dem zu dotierenden Halbleitersubstrat und der Lichtquelle eine Maske eingebracht wird, die in Abhängkeit der zu dotierenden Gebiete gleicher Dotierstoffkonzentration unterschiedlich dick ausgeführte Maskenbereiche bis hin zu durchgehenden Maskenlöchern aufweist, daß zwischen der Maske und dem zu dotierenden Halbleitersubstrat Dotierstoffatome eingebracht werden, und daß zur Diffusionsdotierung des Halbleitersubstrats mit Rapid Thermal Processing die Maskenoberfläche von der Lichtquelle bestrahlt wird.

Der Erfindung liegt die Idee zugrunde, daß auf bzw. über dem zu dotierenden Halbleitersubstrat eine Maske angeordnet ist, die unterschiedlich dick ausgeführte Maskenbereiche bishin zu durchgehenden Maskenlöchern aufweist. Auf diese Weise trifft das von der Beleuchtungsquelle kommende Licht an geeigneten Stellen, an denen die Maske durchgehende Löcher aufweist, direkt auf das Grundsubstrat auf und tritt unmittelbar in Wechselwirkung mit der Substratoberfläche. An Stellen, an denen die Maske die Substratoberfläche verdeckt, gelangen nur jene Strahlungsanteile des von der Beleuchtungseinheit herrührenden Emissionsspektrum die Substratoberfläche, die von dem Maskenmaterial nicht absorbiert werden. Zusätzlich wirkt auch die Wärmestrahlung der Maske selbst auf die durch die Maske abgedeckten Halbleitersubstratbereiche, so daß zusätzlich zu den die Maske durchdringenden elektromagnetischen Strahlanteile die von der Maske herrührende charakteristische Schwarzkörperstrahlung auf die Halbleitersubstratoberfläche einwirkt und das Temperaturprofil auf der Halbleitersubstratoberfläche beeinflußt.

Durch die erfindungsgemäße Kombination von der an sich bekannten Technik des Rapid Thermal Processings mit einer geeigneten Abdeckmaske wird die zu bearbeitende Halbleitersubstratoberfläche mit einer gewünschten flächig unterschiedlichen spektralen Verteilung des auf die Halbleiteroberfläche einwirkenden Strahlungsfeldes beaufschlagt, so daß sich in verschiedenen Bereichen der zu dotierenden Halbleitersubstratoberfläche unterschiedliche, den Diffusionsprozeß bestimmende Diffusionskonstanten einstellen lassen.

Hierzu wird vorzugsweise zwischen der Maske und der zu dotierenden Halbleitersubstratoberfläche eine Zwischenschicht eingebracht, die die Dotierstoffatome enthält. Je nach den sich einstellenden Diffusionskonstanten bedingt durch die unterschiedliche spektrale Verteilung der auf die Substratoberfläche einwirkenden Strahlung, läuft der Diffusionsprozeß, der für das Einbringen der Dotierstoffatome in das Halbleitergrundsubstrat verantwortlich ist, an verschiedenen Stellen unterschiedlich schnell ab.

So laufen Diffusionsprozesse an Stellen des Halbleitergrundsubstrates, die ungehindert von der Beleuchtungseinheit bestrahlt werden, aufgrund der optischen Anregung durch das kurzwelligere Licht beschleunigt ab. An Stellen, über denen Maskenmaterial vorgesehen ist, dringen die Dotierstoffatome hingegen verlangsamt in die Substratoberfläche ein.

Bei geeigneter Wahl der Maske, können auf diese Weise Dotierstoffprofile innerhalb des Halbleitergrundsubstrates erzeugt werden, zu denen nur ein einziger Prozeßschritt, nämlich der vorstehend beschriebene Belichtungsvorgang mit einer Belichtungszeit von ca. 10 Sekunden und bei einer Prozeßtemperatur von etwa 900°C, erforderlich ist.

### Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:
- Fig. 1a und b: alternative Maskenanordnungen gemäß des erfindungsgemäßen Verfahrens,
- Fig. 2: Diagramm zur Abhängigkeit der Eindringtiefe von Dotierstoffatomen in Abhängigkeit des Abschattungsgrades,
- Fig. 3a bis h: Verfahrensschritte zur Herstellung einer Zwei-Stufen-Emitter-Solarzelle nach dem Stand der Technik.

### Darstellung von Ausführungsbeispielen

In den Teilbildern a bis h der Figur 3 sind die Herstellungsschritte für zwei Homoübergänge in einem Halbleitersubstrat, die in Zwei-Stufen-Emitter-Solarzellen eingesetzt werden, beschrieben. Wesentlicher Nachteil des bekannten Verfahrens sind die beiden getrennt durchzuführenden Diffusionsschritte zur Herstellung des ersten tiefreichenden n++-Diffusionsgebietes und der danach folgenden seitlich angrenzenden im Rahmen einer homogenen Diffusion zu erhaltenden n+-Diffusionsbereiche. Beide Diffusionsprozesse erfordern Prozeßtemperaturen von über 1000°C. Um derart hohe Temperaturen und insbesondere die Durchführung des zweiten Diffusionsprozesses zu vermeiden, wird das zu dotierende Halbleitergrundsubstrat mit den Mitteln der vorstehend beschriebenen Rapid Thermal Processing bearbeitet.

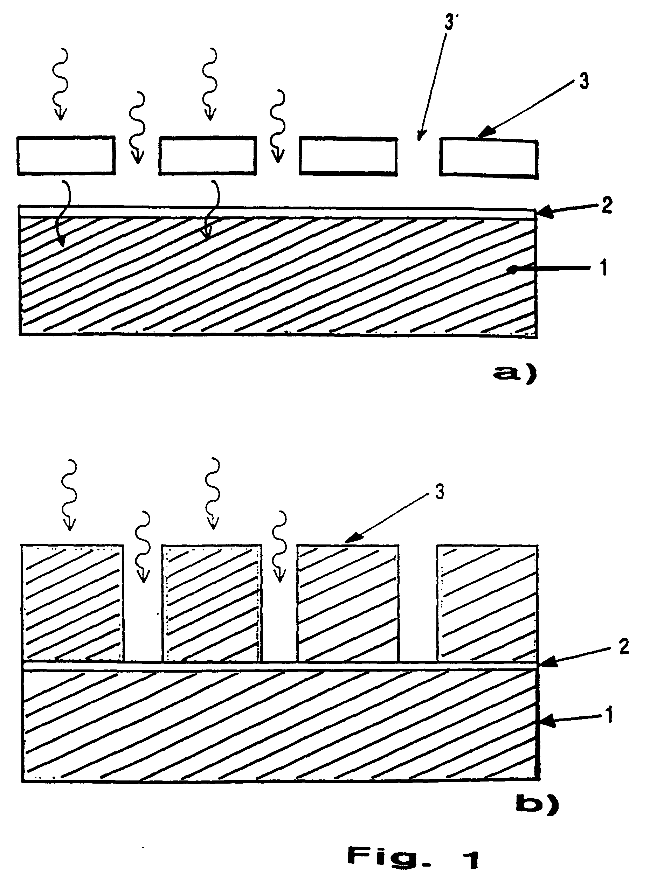

Gemäß Figur 1a wird ein Halbleitergrundsubstrat 1 mit einem die Dotierstoffatome enthaltenen filmartigen Überzug 2 beaufschlagt. Vorzugsweise wird der Überzug mit den Mitteln an sich bekannter Schleuderverfahren, bspw. Spin-on-Techniken, auf das Halbleitersubstrat aufgebracht. Direkt oder beabstandet über dem filmartigen Überzug 2 ist eine Maske 3, die durchgehende Öffnungen 3' aufweist, angeordnet. Oberhalb der Maske ist eine nicht in der Figur 1a dargestellte Beleuchungseinheit vorgesehen, deren Emissionsspektrum UV-Anteile enthält. Die von der Lichtquelle ausgehenden Strahlen treffen an Stellen der Maske 3 auf das Maskenmaterial und werden von dieser in geeigneter Weise absorbiert. Strahlungsanteile, die die Maske durchdringen, gelangen durch die Dotierstoffschicht 2 in das Halbleitersubstrat 1, in dem sie in Wechselwirkung mit dem Halbleitermaterial treten. An Stellen, an denen die Maske 3 Öffnungen aufweist, können die von der Lichtquelle ausgehenden Strahlen direkt durch die Dotierstoffschicht 2 in das Halbleitermaterial 1 ungehindert gelangen. Je nach Strahlungsanteil stellen sich in den oberflächennahen Halbleitersubstratschichten die für den Diffusionsvorgang bestimmenden Diffusionskonstanten geeignet ein.

In Bereichen, an denen die Strahlungsanteile ungehindert in das Halbleitersubstrat eindringen können, erfolgt der Diffusionsvorgang schneller als in Bereichen, die durch die Maske 3 abgedeckt sind. Durch die optisch angeregte Dotierstoffdiffusion und der sich durch die spektrale Verteilung an der Halbleitersubstratoberfläche einstellende, lokal unterschiedliche Diffusionsprozeß kann mit Hilfe nur eines einzigen Prozeßschrittes das gleiche Ergebnis erhalten werden, das unter Abfolge der in Figur 3a bis h dargelegten Prozeßschritte zu erhalten ist. Mit Hilfe der erfindungsgemäßen Vorgehensweise sind die bekannten Dotierverfahren zur Herstellung von Homoübergängen erheblich abzukürzen, wodurch die Herstellkosten erheblich reduziert werden können.

Um Kontaminationsprobleme bei der Fertigung von Halbleiterbauelementen auszuschließen, verwendet man als Maskenmaterial das gleiche Material, aus dem das Halbleitersubstrat besteht. So können gemäß Figur 1b die Wafer-Abschnitte 3 direkt über der Dotierstoffschicht 2 auf dem Halbleitergrundsubstrat 1 aufliegen. Bei diesem direkten Kontakt der Maske 3 mit dem Halbleitersubstrat kann die sich durch die unterschiedliche Strahlungsverteilung ergebende Diffusion durch den bereits erwähnten Temperatureffekt noch verstärkt werden. So ist zum einen die Lichtabsorption, an der der Lichtquelle gegenüberliegenden Oberfläche der Maske bzw. der Substratoberfläche am größten, doch nimmt sie in Abhängigkeit der Wellenlänge mit zunehmender Durchdringungstiefe exponentiell ab. Entsprechend der Abnahme der Lichtabsorption ist auch die damit verbundene Wärmeerzeugung innerhalb der jeweiligen Materialien inhomogen. Dies führt wie bereits beschrieben zu unterschiedlichen Diffusionskonstanten. Durch die direkte Kontaktierung des Maskenmaterials mit der Substratoberfläche tritt aufgrund geänderter thermischer Masse eine inhomogene Erwärmung des Halbleitersubstrates auf, die ebenso wie die Strahlungseinwirkung innerhalb des Halbleitermaterials zu unterschiedlichen Diffusionskonstanten führt.

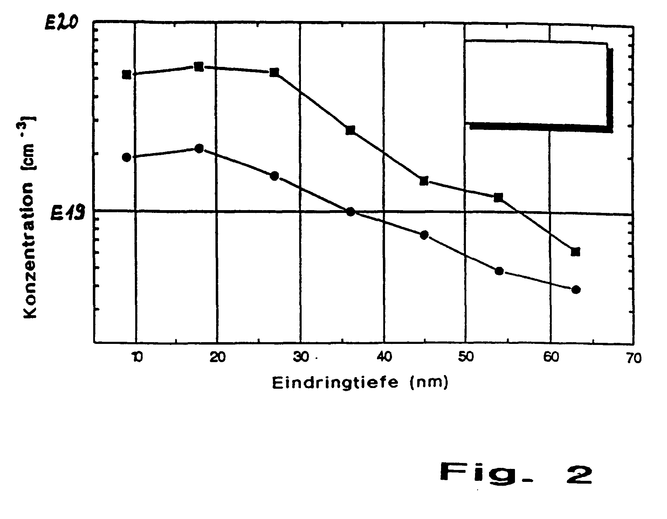

Aus Figur 2 ist ein Diagramm zu entnehmen, das die Eindringtiefe einzelner Dotierstoffatome im Bereich des Halbleitersubstrates ohne Maskenabschirmung (siehe hierzu die Kästchen-Linie) im Verhältnis zur Eindringtiefe von Dotierstoffatomen im Halbleiterbereich, der von der Maske abgedeckt ist (siehe mit Punkten durchsetzte Linie), darstellt. Die Gegenüberstellung beider Graphen zeigt deutlich, daß die Konzentrationsanreicherungen innerhalb der einzelnen Tiefenregionen im Halbleitersubstrat von Dotierstoffatomen im Falle der mit den Kästchen durchsetzten Linienzuges größer ist als im Falle der mit den Punkten durchsetzten Linienzuges. Dies bedeutet, daß die Diffusion an Stellen, die von der Maske nicht abgedeckt sind, effektiver und schneller abläuft als an Stellen, an denen die Maske das Halbleitersubstrat abdeckt. Somit ist es möglich, mit nur einem einzigen Verfahrensschritt Dotierungsbereiche innerhalb des Halbleitersubstrates herzustellen, die nach Beendigung der Beleuchtungszeit angrenzender Dotierbereiche mit jeweils unterschiedlichen Dotierstoffkonzentrationen erzeugt. Wesentliche Einflußparameter auf die Diffusionsvorgängen bilden dabei die Strahlungs- und Temperaturverhältnisse an den einzelnen Halbleitersubstratoberflächen, die durch die charakteristische Ausbildung der Maske geeignet eingestellt werden können.

Mit Hilfe des vorbeschriebenen Verfahrens ist die Herstellung auch sogenannter Back Surface Field-Solarzellen möglich, deren Zellenrückseite durch p/p+-Homoübergängen charakterisiert sind.

## Patentansprüche

1. Dotierverfahren zur Herstellung von Homoübergängen in Halbleitersubstraten, in die im Wege der Diffusion Dotierstoffe eindringen, mit einer Lichtquelle, deren Emissionsspektrum UV-Anteile enthält und die auf die Halbleitersubstratoberfläche gerichtet ist,
**dadurch gekennzeichnet, daß** zwischen dem zu dotierenden Halbleitersubstrat und der Lichtquelle eine Maske eingebracht wird, die in Abhängkeit der zu dotierenden Gebiete gleicher Dotierstoffkonzentration unterschiedlich dick ausgeführte Maskenbereiche bis hin zu durchgehenden Maskenlöchern aufweist,
daß zwischen der Maske und dem zu dotierenden Halbleitersubstrat Dotierstoffatome eingebracht werden, und daß zur Diffusionsdotierung des Halbleitersubstrats mit Rapid Thermal Processing die Maskenoberfläche von der Lichtquelle bestrahlt wird.

2. Dotierverfahren nach Anspruch 1,
**dadurch gekennzeichnet, daß** die Dotierstoffatome in einem filmartigen Überzug auf dem Halbleitersubstrat enthalten sind, der im Schleuderverfahren, durch Aufsprühen oder per Siebdruck aufgebracht wird.

3. Dotierverfahren nach Anspruch 1 oder 2,
**dadurch gekennzeichnet, daß** die Maske aus dem gleichen Material wie das Halbleitersubstrat besteht.

4. Dotierverfahren nach einem der Ansprüche 1 bis 3,
**dadurch gekennzeichnet, daß** zur Erzeugung hoher Dotierstoffkonzentrationen innerhalb des Halbleitermaterials die Maske Öffnungen aufweist, durch die die Beleuchtungsstrahlung ungehindert auf die Substratoberfläche gelangt.

5. Dotierverfahren nach einem der Ansprüche 1 bis 4,
**dadurch gekennzeichnet, daß** die Maske aus Halbleiterstreifen besteht, die auf die Substratoberfläche aufgebracht werden.

6. Dotierverfahren nach einem der Ansprüche 1 bis 5,
**dadurch gekennzeichnet, daß** zur Herstellung einer 2-Stufen-Emitter Solarzelle eine Maske verwendet wird, die eine konstante Maskendicke aufweist und an den Stellen Löcher vorsieht, an denen innerhalb des Halbleitersubstrats höhere Dotierstoffkonzentrationen vorgenommen werden.

7. Dotierverfahren nach einem der Ansprüche 1 bis 6,
**dadurch gekennzeichnet, daß** die Bestrahlungszeit ca. 10 Sekunden bei einer Prozeßtemperatur von ca. 900°C beträgt.

8. Dotierverfahren nach einem der Ansprüche 1 bis 7,
**dadurch gekennzeichnet, daß** als Maske eine Siliziumlochmaske verwendet wird.

9. Dotierverfahren nach einem der Ansprüche 1 bis 8,
**dadurch gekennzeichnet, daß** die unterschiedlich dick ausgebildete Maske zu einer Variation der Bestrahlungsstärke und des Strahlenspektrums führt und bei direktem Kontakt mit dem Halbleitersubstrat das Temperaturprofil auf der Substratoberfläche beeinflusst.

## Claims

1. Doping method for producing homo-junctions in semiconductor substrates into which impurities penetrate by way of diffusion, with a light source whose emission spectrum contains UV fractions and which is directed onto the semiconductor substrate surface,
**characterised in that** a mask is inserted between the semiconductor substrate to be doped and the light source, which mask presents mask areas formed with varying thickness up to through-passing mask holes, in correspondence with the areas to be doped with the same impurity concentration,
that impurity atoms are introduced between the mask and the semiconductor substrate to be doped,
and that the mask surface is exposed to the light source for diffusion doping of the semiconductor substrate with a Rapid Thermal Processing technique

2. Doping method according to Claim 1,
**characterised in that** the impurity atoms are contained in a film-like coating on the semiconductor substrate, which coating is applied by a spin-on technique, by spraying or by screen printing.

3. Doping method according to Claim 1 or 2,
**characterised in that** the mask consists of the same material as the semiconductor substrate.

4. Doping method according to any of the Claims 1 to 3,
**characterised in that** for the production of high impurity concentrations within the semiconductor material said mask presents openings through which the illuminating radiation arrives on the substrate surface, without being shielded off.

5. Doping method according to any of the Claims 1 to 4,
**characterised in that** said mask consists of strips of semiconductor material which are applied on the substrate surface.

6. Doping method according to any of the Claims 1 to 5,
**characterised in that** for the production of a two-stage emitter solar cell a mask is used which presents a constant mask thickness and presents holes at the locations where higher impurity concentrations are created within the semiconductor substrate.

7. Doping method according to any of the Claims 1 to 6,
**characterised in that** the exposure time is roughly 10 seconds at a process temperature of 900 °C approximately.

8. Doping method according to any of the Claims 1 to 7,
**characterised in that** a perforated silicon mask is used as mask.

9. Doping method according to any of the Claims 1 to 8,
**characterised in that** said mask presenting a configuration of varying thickness results in a variation of the radiation intensity and the radiation spectrum and takes an influence on the temperature profile on the substrate surface in the case of direct contact with the semiconductor substrate.

## Revendications

1. Procédé de dopage pour la production d'homo-jonctions dans des substrats semi-conducteurs, dans lesquelles des dopants pénètrent par voie d'une étape de diffusion, moyennant une source de lumière dont le spectre d'émission contient des fractions en UV et qui est dirigée vers une face du substrat semi-conducteur,
**caractérisé en ce qu'**un masque est introduit entre le substrat semi-conducteur à doper et la source lumineuse, ce masque présentant des zones de masque formées à une épaisseur variante, jusqu'aux trous, qui traversent par le masque, en correspondance avec les zones à doper à la même concentration en dopant,
**en ce que** des atomes du dopant sont introduits entre le masque et le substrat semi-conducteur à doper, et
**en ce que** la face du masque est exposée à la source lumineuse pour le dopage par diffusion du substrat semi-conducteur par une technique dite Rapid Thermal Processing.

2. Procédé de dopage selon la revendication 1,
**caractérisé en ce que** les atomes du dopant sont contenus dans un revêtement similaire à un film sur le substrat semi-conducteur, ce revêtement étant déposé par une technique dite spin-on, par pulvérisation ou par sérigraphie.

3. Procédé de dopage selon la revendication 1 ou 2,
**caractérisé en ce que** le masque consiste en le même matériau que le substrat semi-conducteur.

4. Procédé de dopage selon une quelconque des revendications 1 à 3,
**caractérisé en ce que** pour la création des hautes concentrations en dopant à l'intérieur du matériau semi―conducteur, ledit masque présente des ouvertures par lesquelles le rayonnement d'éclairage arrive sur la surface du substrat, sans étant obstruée par un effet d'écran.

5. Procédé de dopage selon une quelconque des revendications 1 à 4,
**caractérisé en ce que** ledit masque consiste en bandes de matériau semi-conducteur, qui sont déposée sur la surface du substrat.

6. Procédé de dopage selon une quelconque des revendications 1 à 5,
**caractérisé en ce que** pour la fabrication d'une cellule solaire à émetteur à deux étages, un masque est utilisé, qui présente une épaisseur de masque constante et des trous aux endroits, où des concentrations en dopant sont créées, qui sont plus haute que les concentrations engendrées à l'intérieur du substrat semi-conducteur.

7. Procédé de dopage selon une quelconque des revendications 1 à 6,
**caractérisé en ce que** le temps d'exposition correspond à 10 secondes environ à une température de processus de 900 °C environ.

8. Procédé de dopage selon une quelconque des revendications 1 à 7,
**caractérisé en ce qu'**un masque perforé en silicium est utilisé comme le masque.

9. Procédé de dopage selon une quelconque des revendications 1 à 8,
**caractérisé en ce que** ledit masque, qui présente une configuration à épaisseur variante, fournit une variation de l'intensité de rayonnement et du spectre de rayonnement, en prenant de l'influence sur le gradient de température sur la surface du substrat au cas de contact direct avec substrat semi-conducteur.
